# EUROPEAN PATENT APPLICATION

(11) **EP 4 770 325 A1**
(43) Date of publication of application: **01.07.2026**
(21) Application number: 25213817.7
(22) Date of filing: 06.11.2025
(51) Int. Cl.: H10D 62/10, H10D 30/01, H10D 30/00, H10D 64/66, H10D 64/68, H10D 84/01, H10D 84/03, H10D 84/85

(54) **SELECTIVE DIPOLE LAYERS FOR NANOWIRE FIELD EFFECT TRANSISTORS**

(30) Priority: 26.12.2024 US 202419002243
(71) Applicant: Intel Corporation, Santa Clara, CA 95054 (US)
(72) Inventor: Lin, Chia-Ching, Portland, OR 97229 (US); Zhang, Kan, Hillsboro, OR 97123 (US); Ghani, Tahir, Portland, OR 97229 (US); Zhang, Yang, Rio Rancho, NM 87124 (US); Lin, Chung-Hsun, Portland, OR 97229 (US); Yeung, Chun Wing, Portland, OR 97229 (US); Hung, Ting-Hsiang, Beaverton, OR 97007 (US); Zhang, Feng, Portland, OR 97229 (US); Xu, Guowei, Portland, OR 97229 (US); Chu, Tao, Portland, OR 97229 (US)
(74) Representative: Samson & Partner Patentanwälte mbB

(57) **Abstract**

Devices, integrated circuit transistor structures, systems, and techniques are described herein related to gate all around field effect transistor circuits having an n-type transistor integrated with a p-type transistor. Each have a stack of nanowires contacted by source and drain structures at opposite ends of the nanowires. The nanowires of the n-type transistor have a layer including lanthanum on the nanowires, and the nanowires of the p-type transistors are absent the layer including lanthanum. The gate structures of the n-type transistor and the p-type transistor have the same gate dielectric, work function metal, and bulk metal.

## Description

### BACKGROUND

Higher performance, lower cost, increased miniaturization, and greater density of integrated circuits (ICs) are ongoing goals of the electronics industry. To maintain the pace of increasing transistor performance, for example, multi-gate transistors such as gate-all-around (GAA) or nanowire transistors are being deployed. In such devices, the gate structure surrounds the channel region on all sides of each nanowire (or nanoribbon) of semiconductor material for improved drive current, device control, and other advantages. The nanowires or nanoribbons of semiconductor material are contacted on opposite sides by source and drain structures, which may be epitaxially grown materials. The gate structure includes a gate dielectric and a gate electrode, which can include materials selected to tune transistor performance, including the threshold voltage of the transistors.

Currently, there are difficulties in tuning device performance due to limitations in the deployment of the gate structure materials, process flows for fabricating transistor structures, and others. It is with respect to these and other considerations that the present improvements have been needed. Such improvements may become critical as the desire to deploy multi-gate transistor structures such as nanowire or nanoribbon field effect transistors becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG.1 is a flow diagram illustrating exemplary methods for forming integrated circuit structures with an n-type transistor integrated with a p-type transistor such that the n-type transistor has a layer including lanthanum on nanowires of the n-type transistor and the p-type transistor is absent the layer including lanthanum;
FIGS. 2, 3, 4, 5, 6, 7, 8, 9, 10 and 11 are cross-sectional side views of example integrated circuit structures as particular fabrication operations of the methods of FIG. 1 are performed;
FIG. 12 is a cross-sectional side view of the integrated circuit structure of FIGS. 10 and 11 incorporated in a multi-layer integrated circuit device structure;
FIG. 13 illustrates exemplary systems employing integrated circuit structures with an n-type transistor integrated with a p-type transistor such that the n-type transistor has a layer including lanthanum on nanowires of the n-type transistor and the p-type transistor is absent the layer including lanthanum; and
FIG. 14 is a functional block diagram of an electronic computing device, all arranged in accordance with at least some embodiments of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/-10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, transistor structures, integrated circuit dies, apparatuses, systems, and techniques are described herein related to integrated circuits with NMOS gate-all-around field effect transistors (GAA-FETs) having a layer including lanthanum directly on the semiconductor material of the transistors and PMOS GAA-FETs absent the layer including lanthanum.

As discussed, multi-gate transistors such as gate-all-around (GAA) or nanowire transistors are being deployed in advanced integrated circuit devices. As used herein, the terms nanowire, nanoribbon, stacked semiconductor structure, and similar terms are used substantially interchangeably to indicate a semiconductor material that extends from a source to a drain such that the semiconductor material is one of two or more such material structures that are separated and vertically aligned. The multiple semiconductor material structures each couple to the same source and drain, and are vertically separated by a gate structure, which may include a gate dielectric and a gate electrode. Thereby, the field effect transistor or device includes a source, a drain, and a stack of semiconductor structures extending between the source and the drain. The source and drain are epitaxial to the semiconductor structures. As used herein the term epitaxial to or similar terms indicate the materials are substantially lattice matched. The stack of semiconductor structures (e.g., two to about eight semiconductor structures) are controlled by the same gate electrode, and work in concert as the channel of the device. As used herein, the term channel region of a semiconductor structure indicates a region of a material layer adjacent to a gate dielectric and gate electrode that is to be controlled by the gate electrode to switch the transistor structure in operation. Notably, a region of a material layer need not be in operation to be characterized as a channel region, channel material, or the like. The term semiconductor structure is used broadly to include nanowires, nanoribbons, and similar terms.

A complementary metal-oxide-semiconductor (CMOS) device or apparatus includes n-type metal-oxide-semiconductor (NMOS) transistors integrated with p-type metal-oxide-semiconductor (PMOS) transistors. The terms n-type and p-type as well as NMOS and PMOS are used in their ordinary meaning to indicate the conductor and dopant type of the semiconductor device. N-type transistors use electrons as carriers and have n-type doped source and drain regions while p-type transistors use holes as carriers and have p-type doped source and drain regions. Exemplary n-type dopants for the source and drain regions include phosphorous and arsenic, such that, for example, the source and drain regions of n-type transistors may be phosphorous and/or arsenic doped epitaxial silicon. Exemplary p-type dopants for the source and drain regions include boron and gallium, such that, for example, the source and drain regions of p-type transistors may be boron and/or gallium doped epitaxial silicon germanium. However, other material systems may be used.

As discussed, current GAA-FET integrated circuits have difficulties including tuning device performance. In some embodiments, an integrated circuit includes an n-type transistor with a layer including lanthanum directly on the semiconductor structures of the n-type transistor such that a gate structure is directly on the layer including lanthanum, and a p-type transistor absent the layer including lanthanum such that the gate structure of the p-type transistor is directly on the semiconductor structures of the p-type transistor. The gate structures of the n-type transistor and the p-type transistor are the same, having the same materials for each of the gate dielectric of the gate structure, the work function metal of the gate structure, and the metal fill of the gate structure. For example, the techniques discussed herein use a dipole-first approach that directly applies a layer including lanthanum on the semiconductor structures of both the n-type transistors and the p-type transistors. The layer including lanthanum is the selectively removed from the semiconductor structures of the p-type transistor, and the gate structures are then simultaneously formed on the n-type transistors and the p-type transistors. Exemplary materials include silicon (Si) semiconductor structures, a high-K gate dielectric material such as hafnium oxide, a titanium nitride (TiN) work function metal, and a tungsten fill metal. However, other material systems may be used.

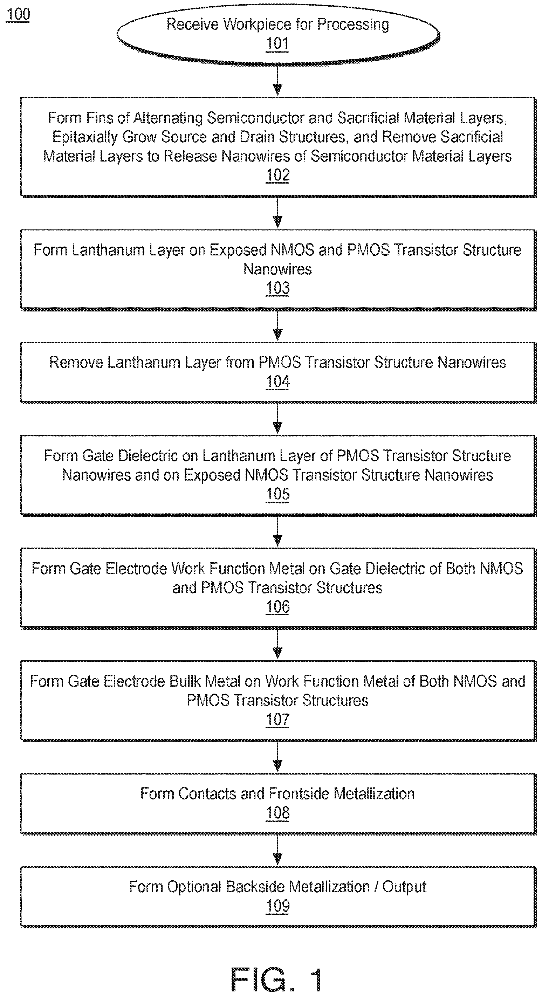

FIG.1 is a flow diagram illustrating exemplary methods 100 for forming integrated circuit structures with an n-type transistor integrated with a p-type transistor such that the n-type transistor has a layer including lanthanum on nanowires of the n-type transistor and the p-type transistor is absent the layer including lanthanum, arranged in accordance with at least some embodiments of the present disclosure. For example, methods 100 may be implemented to fabricate integrated circuit structure 1000 or any other integrated circuit structures discussed herein. In the illustrated implementation, methods 100 may include one or more operations as illustrated by operations 101-109. However, embodiments herein may include additional operations, certain operations being omitted, or operations being performed out of the order provided.

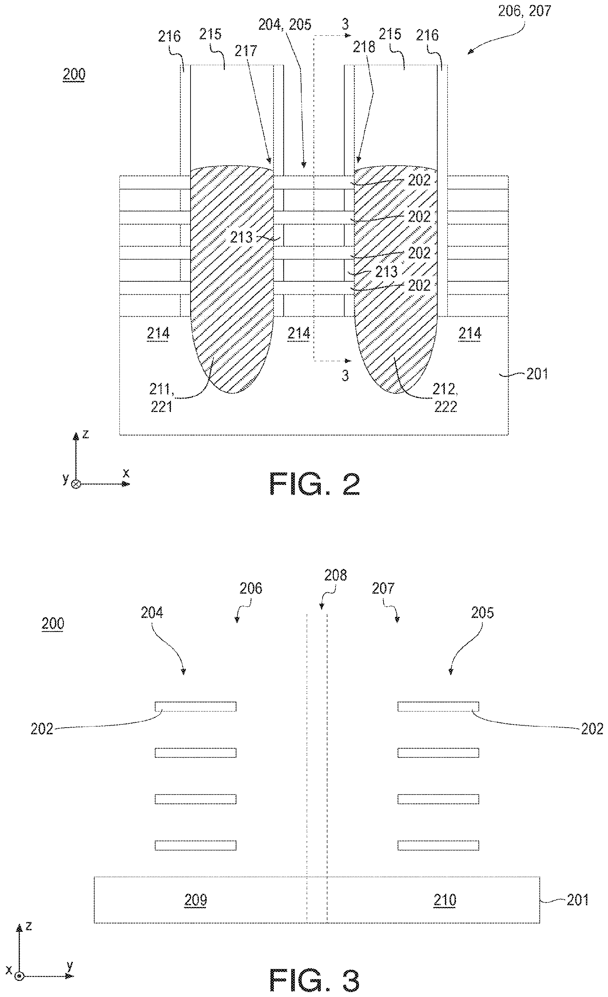

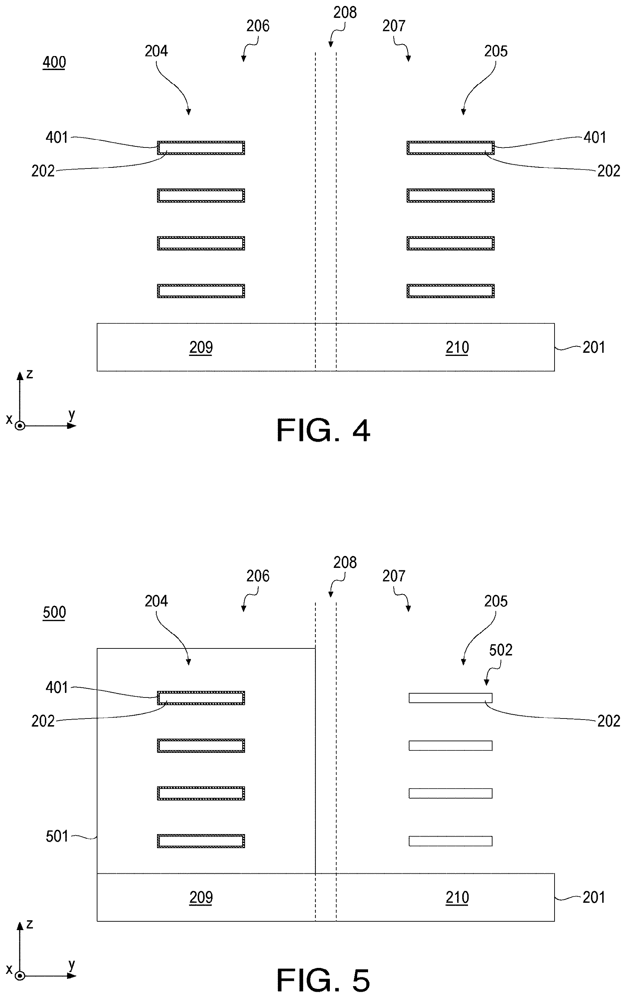

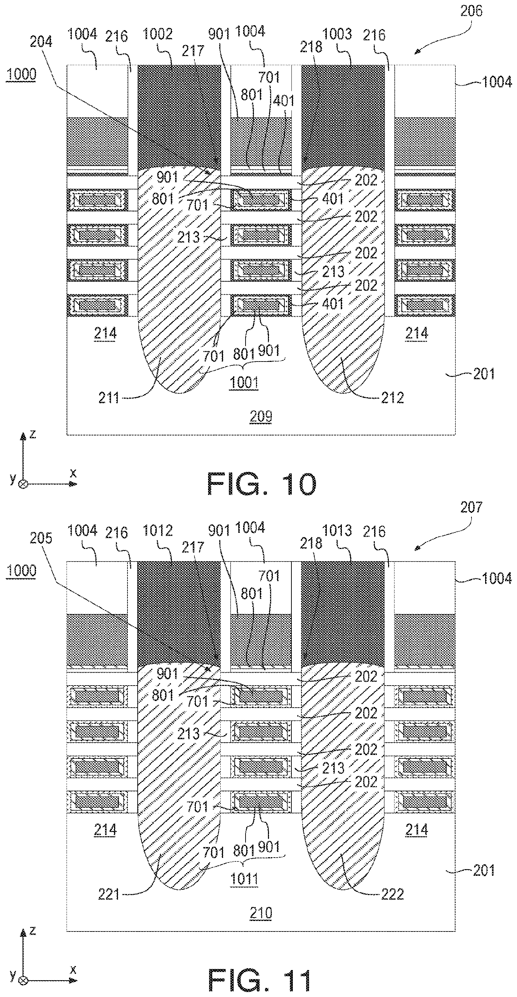

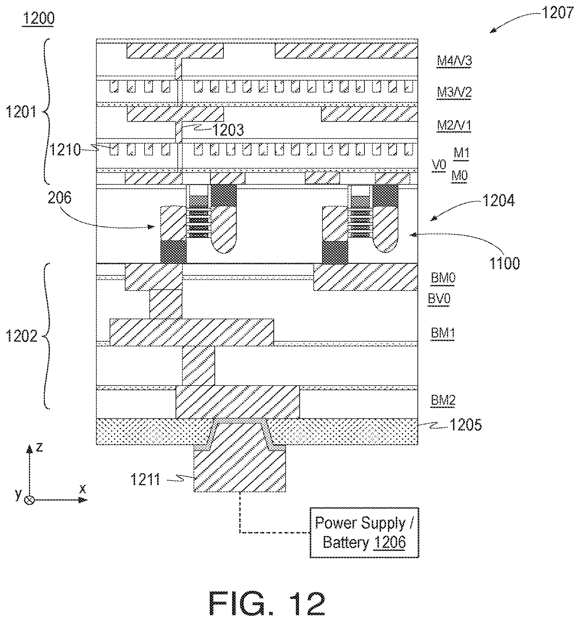

FIGS. 2, 3, 4, 5, 6, 7, 8, 9, 10 and 11 are cross-sectional side views of example integrated circuit structures as particular fabrication operations of methods 100 are performed, arranged in accordance with at least some implementations of the present disclosure. FIG. 2 is a cross-sectional side view taken at a gate cut of an example integrated circuit structure showing released nanoribbons between a source and a drain of an example transistor structure. FIG. 3 is a cross-sectional side view of the example integrated circuit structure of FIG. 2 taken at a fin cut of the example transistor structures. FIGS. 4, 5, 6, 7, 8, and 9 are cross-sectional side views of example integrated circuit structures taken at the fin cut of the example transistor structures showing semiconductor structures, layers including lanthanum, and gate structures. FIG. 10 is a cross-sectional side view of an example resultant n-type transistor structure taken at the gate cut and FIG. 11 is a cross-sectional side view of an example resultant p-type transistor structure taken at the gate cut of an example integrated circuit structure. FIG. 12 is a cross-sectional side view of the integrated circuit structure of FIGS. 10 and 11 incorporated in a multi-layer integrated circuit device structure, arranged in accordance with at least some implementations of the present disclosure.

Processing begins at operation 101, where a workpiece such as a substrate is received for processing. The substrate may include any suitable substrate as discussed herein such as a silicon wafer or the like. In some embodiments, the substrate includes underlying devices or electrical interconnects. Processing continues at operation 102, where alternating layers of semiconductor material layers and sacrificial layers are formed over the workpiece or substrate, the alternating (or interleaved) layers of semiconductor material layers and sacrificial layers are patterned to form fin structures of the interleaved stack of semiconductor material layers and sacrificial layers, dummy gate and spacer structures are formed, epitaxial source and drain materials are epitaxially grown or deposited via the exposed ends of at least the semiconductor material layers, and the sacrificial layers are removed to release the nanowires of semiconductor materials.

The alternating layers of semiconductor material layers and sacrificial layers may be formed using any suitable technique or techniques such as epitaxial growth techniques, deposition techniques or the like. The semiconductor material layers, and sacrificial layers may include any suitable materials and may have any thickness characteristics discussed herein below. The alternating layers of semiconductor material layers and sacrificial layers may be patterned into any number of fins using any suitable technique or techniques such as lithography and etch techniques. When patterned, the resultant semiconductor structures or nanoribbons are defined for use in a transistor structure. In some embodiments, the patterning includes one or more etches such to define the fin critical dimensions of the semiconductor material layers, and the formation of dummy gate and spacer structures. Depending on process flow, the sacrificial layers may be recessed at ends of the stacks and backfilled with dielectric spacer material.

Following fin formation, epitaxial source and drain materials are epitaxially grown or deposited via the exposed ends of at least the semiconductor material layers. For example, n-type and p-type source and drain structures are formed while the other transistor structure is covered by a mask as is known in the art. In some embodiments, a single bulk material is grown or deposited from opposite ends of the fins and in some embodiments, an epitaxial nucleation layer may be grown or deposited, followed by bulk growth or deposition of the source and drain materials. The source and drain materials may be any suitable materials for the pertinent n-type or p-type transistor. In some embodiments, the source and drain materials of the n-type transistor structures include n-type dopants such as phosphorous and/or arsenic and the n-type source and drain materials are, for example, phosphorous and/or arsenic doped epitaxial silicon. In some embodiments, the source and drain materials of the p-type transistor structures include p-type dopants such as boron and/or gallium and the p-type source and drain materials are, for example, boron and/or gallium doped epitaxial silicon germanium. The epitaxial source and drain materials may be deposited using any suitable technique or techniques such as chemical vapor deposition (CVD) including dopant materials.

After source and drain formation, the interleaved sacrificial material layers are removed using selective etch techniques such as selective wet etch techniques to release the nanowires of semiconductor material. For example, an etch selectivity exists between the silicon germanium of the sacrificial materials and the silicon of the semiconductor material layers. In some embodiments, the released nanowires are supported by the epitaxial source and drain materials as well as the discussed dielectric spacers vertically between the nanowires.

FIG. 2 is a cross-sectional side view of an example integrated circuit structures 200 taken at a gate cut of integrated circuit structures 200. The view of FIG. 2 is used to illustrate both n-type transistor structures 206 and p-type transistor structures 207, which have substantially the same structures with some material differences as discussed herein below. As shown, n-type transistor structures 206 and p-type transistor structures 207 are built-up over a substrate 201 and include semiconductor structures 202. Substrate 201 may include any suitable material or materials and, in some embodiments, substrate 201 includes a material or materials having the same or a similar composition with respect to semiconductor structures 202. In some embodiments, substrate 201 and semiconductor structures 202 include a Group IV material (e.g., silicon). In some embodiments, substrate 201 and semiconductor structures 202 include a substantially monocrystalline material. In some embodiments, substrate 201 includes a buried insulator layer (e.g., SiO₂), for example, of a semiconductor-on-insulator (SOI) substrate and/or isolation insulator regions and the like.

Semiconductor structures 202 may include any number of layers and may be characterized as semiconductor structures, channel semiconductors, nanoribbons, nanowires, or the like. As shown, n-type transistor structures 206 include a stack 204 of semiconductor structures 202 and p-type transistor structures 207 include a stack 205 of semiconductor structures 202. In some embodiments, semiconductor structures 202 are the same between n-type transistor structures 206 and p-type transistor structures 207. However, they may be different in some embodiments. Stacks 204, 205 may include any number of semiconductor structures 202 such as two, three, four (as illustrated), five, six, seven, eight or more layers with even numbers of semiconductor structures 202 typically being deployed. Semiconductor structures 202 were separated and interleaved with sacrificial material layers, which were removed as discussed above. In some embodiments, semiconductor structures 202 are silicon such as monocrystalline silicon. Semiconductor structures 202 may have any suitable thicknesses (i.e., measured in the z-dimension) such as thicknesses in the range of 2 nm to 8 nm. In some embodiments, each of semiconductor structures 202 have a thickness of not less than 2 nm.

During formation of fins of n-type transistor structures 206 and p-type transistor structures 207, dummy gate structure 215 and spacer 216 are formed. The fabrication of the fins of n-type transistor structures 206 and p-type transistor structures 207 may establish any suitable source to drain length defined in the x-dimension such as a length in the range of 3 nm to 20 nm. Also as shown, the patterning may form subfins 214. Dummy gate structures 215 and spacer 216 may be any suitable materials such as polysilicon and dielectric materials, respectively.

As discussed, n-type transistor structures 206 include source structure 211 and drain structure 212, which have n-type doped materials (e.g., phosphorous and/or arsenic doped epitaxial silicon), and p-type transistor structures 207 include source structure 221 and drain structure 222, which have p-type doped materials (e.g., boron and/or gallium doped epitaxial silicon germanium). In some embodiments, source structure 211, 221 and drain structure 212, 222 cach include an epitaxial nucleation layer (not shown) and a bulk epitaxial material. For example, epitaxial nucleation layers may have a lower dopant concentration than the bulk material. As shown, source structures 211, 221 and drain structures 212, 222 are epitaxial to exposed ends 217, 218 of stacks 204, 205.

As discussed, after fabrication of source structures 211, 221 and drain structures 212, 222, semiconductor structures 202 are released to form openings between adjacent ones of semiconductor structures 202. Such nanowire release processing may include any suitable material removal such as wet etch processing. In some embodiments, semiconductor structures 202 are supported by dielectric spacers 213, which may also electrically isolate source structures 211, 221 and drain structures 212, 222 from subsequent gate structures. Dielectric spacers 213 may be any suitable material such as silicon oxide, silicon nitride, silicon oxynitride, or the like.

FIG. 3 is a cross-sectional side view of integrated circuit structure 200 taken at the fin cut shown in FIG. 2. As discussed, the cross-sectional side view of FIG. 2 is used illustrate both n-type transistor structures 206 and p-type transistor structures 207. In the context of the fin cut of FIGS. 3 to 9, n-type transistor structures 206 and p-type transistor structures 207 are each separately illustrated as separated by a spacing 208. Notably, the views illustrated herein are presented to provide clarity in the discussion of the embodiments, and n-type transistor structures 206 and p-type transistor structures 207 may be layer out in any suitable manner in an integrated circuit structure.

Notably, FIG. 3 illustrates stack 204 of semiconductor structures 202 of n-type transistor structures 206 over a portion 209 of substrate 201 where one or more n-type transistors are to be fabricated and stack 205 of semiconductor structures 202 of p-type transistor structures 207 over a portion 210 of substrate 201 where one or more p-type transistors are to be fabricated. Such n-type transistor structures 206 include a dipole layer including lanthanum directly on semiconductor structures 202 while p-type transistor structures 207 are absent the dipole layer as discussed herein below.

Returning to FIG. 1, processing continues at operation 103, where a dipole layer such as a layer including lanthanum is formed on the exposed transistor structure nanowires of the n-type transistor structures and the p-type transistor structures. The dipole layer may be formed using any suitable technique or techniques such as deposition techniques. In some embodiments, the deposited dipole layer is substantially pure or pure lanthanum. In some embodiments, the deposited dipole layer is a substantially pure or pure compound of lanthanum and oxygen (i.e., lanthanum oxide). The dipole layer may be deposited using atomic layer deposition (ALD), CVD, or physical vapor deposition (PVD), or the like. In some embodiments, the deposition of the dipole layer is followed by a low temperature anneal.

FIG. 4 is a cross-sectional side view of an example integrated circuit structure 400 similar to integrated circuit structure 200, after formation of dipole layers 401 on each of semiconductor structures 202. Notably, dipole layers 401 are formed on each of semiconductor structures 202 of stack 204 of semiconductor structures 202 of n-type transistor structures 206 and on cach of semiconductor structures 202 of stack 205 of semiconductor structures 202 of p-type transistor structures 207. As discussed, dipole layers 401 may be formed using any suitable conformal deposition techniques. Dipole layers 401 may be substantially pure or pure lanthanum or a substantially pure or pure compound of lanthanum and oxygen. Dipole layers 401 may be any suitable thicknesses such as thicknesses in the range of 5 angstroms to 20 angstroms. In some embodiments, dipole layers have a thickness of not less than 5 angstroms.

Returning to FIG. 1, processing continues at operation 104, where the dipole layer deposited at operation 103 is selectively removed from the p-type transistor structures. The dipole layer may be selectively removed from the p-type transistor structures using any suitable technique or techniques. In some embodiments, the n-type transistor structures are covered by a mask material such as oxide and the dipole layers are selectively removed from the semiconductor structures of the p-type transistor structures using etch processing such as wet etch or wet clean processing. In some embodiments, the dipole layer is relatively easy to remove and may be removed using a water etch or a water-based etch.

FIG. 5 is a cross-sectional side view of an example integrated circuit structure 500 similar to integrated circuit structure 400, after formation of a mask layer 501 to cover n-type transistor structures 206 while exposing p-type transistor structures 207, and after selective removal of dipole layers 401 from semiconductor structures 202 of p-type transistor structures 207 to expose surfaces 502. Mask layer 501 may be any suitable material or materials that protect n-type transistor structures 206 during selective removal of dipole layers 401, such as silicon oxide. In some embodiments, mask layer 501 is formed by applying a bulk material layer, optional planarization of the bulk material layer, forming a patterned layer such as a patterned resist layer on the bulk material layer, and etch processing to form mask layer 501. Mask layer 501 covers n-type transistor structures 206 while exposing p-type transistor structures 207 for subsequent processing to remove dipole layers 401 from semiconductor structures 202 of p-type transistor structures 207.

Dipole layers 401 may then be selectively removed from semiconductor structures 202 of p-type transistor structures 207 using any suitable technique or techniques such as water etch or a water-based etch processing. As shown, dipole layers 401 remain on semiconductor structures 202 of n-type transistor structures 206 for Vt tuning as discussed herein.

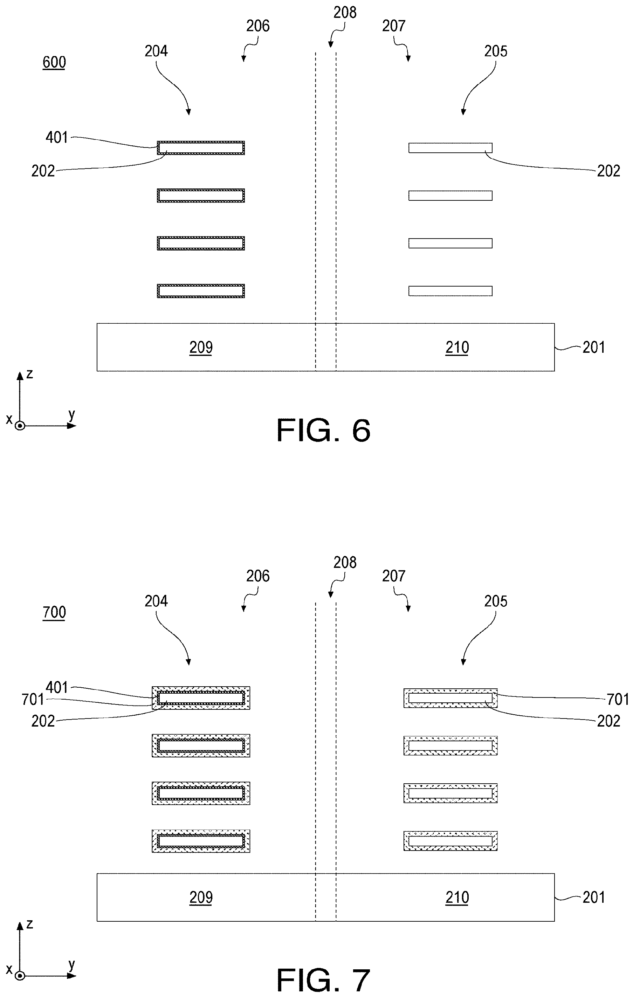

FIG. 6 is a cross-sectional side view of an example integrated circuit structure 600 similar to integrated circuit structure 500 after removal of mask layer 501. Notably, mask layer 501 is subsequently removed using any suitable technique or techniques such as selective wet etch techniques such that n-type transistor structures 206 and p-type transistor structures 207 may be simultaneously processed.

Returning to FIG. 1, processing continues at operation 105, where a gate dielectric of a gate structure is formed on the exposed dipole layers of the n-type transistor structures and on the exposed semiconductor structures of the p-type transistor structures. Notably, the gate dielectric is formed on the exposed materials of the n-type transistor structures and the p-type transistor structures such that resultant n-type transistors and p-type transistors each have substantially the same gate dielectric material(s), work function metal(s), and bulk electrode metal(s) as each are formed simultaneously on the n-type transistor structures and the p-type transistor structures at operations 105, 106, 107. As used herein, the terms gate or gate structure indicate a structure inclusive of a gate dielectric and a gate electrode. The terms gate electrode or gate electrode structure indicate a structure inclusive of a gate electrode work function metal and a gate electrode bulk metal.

FIG. 7 is a cross-sectional side view of an example integrated circuit structure 700 similar to integrated circuit structure 600, after formation of gate dielectric layers 701 on dipole layers 401 of n-type transistor structures 206 and on semiconductor structures 202 of p-type transistor structures 207. Gate dielectric layers 701 may be formed using any suitable technique or techniques such as CVD, ALD, PVD, or the like, with ALD being preferred in some embodiments.

In some embodiments, each of gate dielectric layers 701 is or includes a layer of aluminum oxide, hafnium oxide, zirconium oxide, titanium silicon oxide, hafnium silicon oxide, or silicon nitride. For example, gate dielectric layers 701 may cach include aluminum and oxygen; hafnium and oxygen; zirconium and oxygen; titanium, silicon, and oxygen; hafnium, silicon, and oxygen; or silicon and nitrogen. In some embodiments, gate dielectric layers 701 is a layer of hafnium oxide. Gate dielectric layers 701 may have any suitable thickness such as a thickness in the range of 1 nm to 4 nm. In some embodiments, gate dielectric layers 701 each have a thickness of not less than 1 nm. In some embodiments, gate dielectric layers 701 may be characterized as a high-k gate dielectric, indicating a material with a high dielectric constant as compared to that of silicon dioxide.

Returning to FIG. 1, processing continues at operation 106, where a work function metal of a gate structure is formed on the exposed gate dielectric layers of both the n-type transistor structures and the p-type transistor structures. The work function metal is formed over a dipole layer (which is on a semiconductor structure) of the n-type transistor structures and over a semiconductor structure (which is absent a dipole layer) of the p-type transistor structures. Therefore, the resultant n-type transistors and p-type transistors each have substantially the same work function metal(s) as each are formed simultaneously on the n-type transistor structures and the p-type transistor structures. The work function metal is part of a gate electrode or electrode structure.

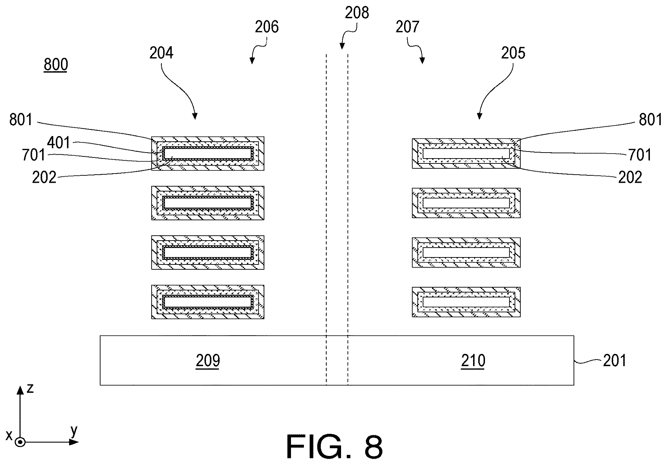

FIG. 8 is a cross-sectional side view of an example integrated circuit structure 800 similar to integrated circuit structure 700, after formation of work function metal layers 801 on gate dielectric layers 701 of n-type transistor structures 206 and on gate dielectric layers 701 of p-type transistor structures 207. Work function metal layers 801 may be formed using any suitable technique or techniques such as CVD, ALD, PVD, ion assisted beam deposition (IBAD), or the like, with PVD being preferred in some embodiments.

In some embodiments, each of work function metal layers 801 is or includes titanium nitride. For example, work function metal layers 801 may each include titanium and nitrogen. Work function metal layers 801 may have any suitable thickness such as a thickness in the range of 1 nm to 5 nm. In some embodiments, work function metal layers 801 each have a thickness of not less than 1 nm.

Returning to FIG. 1, processing continues at operation 107, where a bulk electrode metal of a gate structure is formed on the exposed work function metal layers of both the n-type transistor structures and the p-type transistor structures. The bulk electrode metal is formed over a dipole layer (which is on a semiconductor structure) of the n-type transistor structures and over a semiconductor structure (which is absent a dipole layer) of the p-type transistor structures. Therefore, the resultant n-type transistors and p-type transistors each have substantially the same bulk electrode metal(s) as discussed herein. The bulk electrode metal is part of a gate electrode or electrode structure with the work function metal(s), with the gate dielectric material(s), work function metal(s), and the bulk electrode metal(s) forming a gate structure of the n-type and p-type transistor structures.

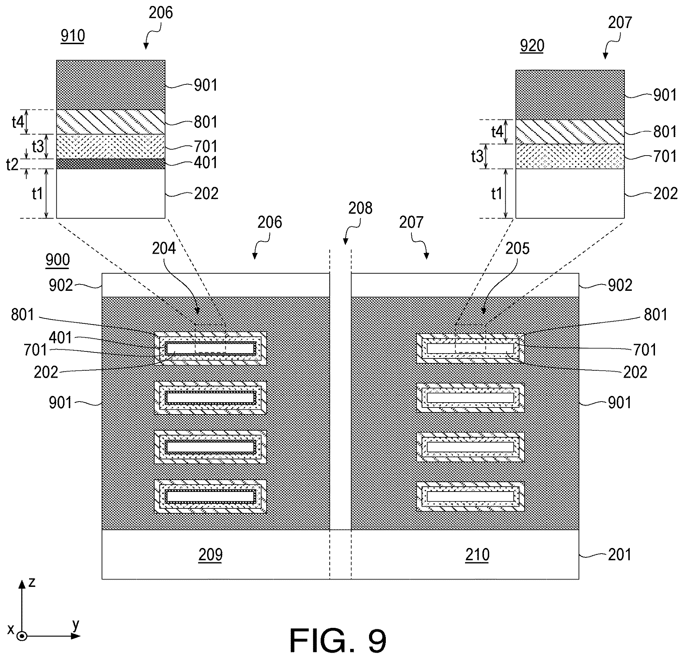

FIG. 9 is a cross-sectional side view of an example integrated circuit structure 900 similar to integrated circuit structure 800, after formation of bulk electrode metals 901 on work function metal layers 801 of n-type transistor structures 206 and on work function metal layers 801 of p-type transistor structures 207. Bulk electrode metals 901 may be formed using any suitable technique or techniques such as CVD, PVD, ion assisted beam deposition (IBAD), or the like, with CVD being preferred in some embodiments. Bulk electrode metals 901 may be any suitable metal or metals. In some embodiments, bulk electrode metals 901 are tungsten. However, other material systems may be used. An isolation layer 902 may be formed over bulk electrode metals 901.

Integrated circuit structure 900 includes one or more n-type transistor structures 206 and one or more p-type transistor structures 207. As also shown in enlarged views 910, 920, n-type transistor structures 206 include semiconductor structures 202, dipole layers 401 on semiconductor structures 202, gate dielectric layers 701 on dipole layers 401, work function metal layers 801 on gate dielectric layers 701, and bulk electrode metals 901 on work function metal layers 801 while p-type transistor structures 207 include semiconductor structures 202, gate dielectric layers 701 on semiconductor structures 202, work function metal layers 801 on gate dielectric layers 701, and bulk electrode metals 901 on work function metal layers 801. Notably, while p-type transistor structures 207 are absent dipole layers 401.

Also as shown, the materials, thicknesses, and other characteristics of gate dielectric layers 701, work function metal layers 801, and bulk electrode metals 901 are substantially the same between n-type transistor structures 206 and p-type transistor structures 207. In some embodiments, dipole layers 401 are or include lanthanum, gate dielectric layers 701 are or include hafnium oxide, work function metal layers 801 are or include titanium nitride, and bulk electrode metals 901 are or include tungsten. However, any materials discussed herein may be deployed.

Semiconductor structures 202 may have any suitable thickness t1 such as a thickness of not less than 2 nm and not more than 8 nm. In some embodiments, thickness t1 is not less than 3 nm and not more than 5 nm. Dipole layer 401 may have any suitable thickness t2 such as a thickness of not less than 5 angstroms and not more than 20 angstroms. In some embodiments, thickness t2 is not less than 10 angstroms and not more than 15 angstroms. Gate dielectric layers 701 have a thickness t3, which may be any suitable thickness such as a thickness of not less than 1 nm and not more than 4 nm. In some embodiments, thickness t3 is not less than 2 nm and not more than 3 nm. Work function metal layers 801 may have any suitable thickness t4 such as a thickness of not less than 1 nm and not more than 5 nm. In some embodiments, thickness t4 is not less than 2 nm and not more than 4 nm. Notably, thicknesses t1, t3, and t4 are substantially the same between n-type transistor structures 206 and p-type transistor structures 207 due to each being formed simultaneously for n-type transistor structures 206 and p-type transistor structures 207.

Returning to FIG. 1, processing continues at operation 108, where any of the source structure, drain structure, and gate structure (i.e., including the gate electrode and gate dielectric) are contacted by frontside metal contacts using any suitable technique or techniques such as patterning and metal deposition processing as is known in the art. For example, frontside contacts may be made to any one or more of the source, drain, and gate of the n-type and p-type transistor structures being fabricated. For example, each of the n-type and p-type transistor structures are three terminal devices to be contacted at the source, drain, and gate, and any of these may be contacted from the frontside or backside of the device structure. The frontside contacts are then interconnected by metallization layers over the frontside contact. In some embodiments, the gate and drain of the transistor structure are contacted from the frontside to provide signal routing and the source of the transistor structure is contacted from the backside to provide power delivery. However, any interconnect routing may be used.

FIG. 10 is a cross-sectional side view of an example resultant n-type transistor structure 206 of an integrated circuit structure 1000, similar to integrated circuit structure 900 taken at the gate cut of n-type transistor structure 206, and after formation of frontside source contact 1002 in contact with source structure 211 and frontside drain contact 1003 in contact with drain structure 212. Also as shown, work function metal layers 801, bulk electrode metal 901, and gate dielectric layer 701 form a gate structure 1001 n-type transistor structure 206. For example, work function metal layers 801 and bulk electrode metal 901 provides a gate electrode, which is part of gate structure 1001 along with and gate dielectric layer 701. Integrated circuit structure 1000 may further include a frontside gate contact (not shown) in contact with gate structure 1001. For example, the gate contact may be into or out of the page of the illustrated cross-sectional side view.

Frontside source contact 1002, frontside drain contact 1003, and the frontside gate contact may be formed using operations known in the art such as lithography patterning of vias and via fill and optional planarization. Such components may include any suitable materials. For example, frontside source contact 1002, frontside drain contact 1003, and the frontside gate contact may include a liner material such as titanium nitride and a fill metal such as tungsten. However, other material systems may be used. Frontside source contact 1002, frontside drain contact 1003, and the frontside gate contact may be embedded in a dielectric material 1004, which may be silicon oxide, silicon nitride, silicon oxynitride, or the like. Over integrated circuit structure 1000, frontside metallization layers may be formed using any suitable technique or techniques such as dual damascene techniques, single damascene techniques, subtractive metallization patterning techniques, or the like. Frontside metallization layers are illustrated herein below with respect to FIG. 12. In some embodiments, only frontside metallization layers are used. In other embodiments, after fabrication of the frontside metallization layers, the workpiece may be mounted to a carrier wafer and backside contacts and metallization layers may be fabricated.

FIG. 11 is a cross-sectional side view of an example resultant p-type transistor structure 207 of integrated circuit structure 1000 taken at the gate cut of p-type transistor structure 207, and after formation of frontside source contact 1012 in contact with source structure 221 and frontside drain contact 1013 in contact with drain structure 222. Work function metal layers 801, bulk electrode metal 901, and gate dielectric layer 701 form a gate structure 1011 of p-type transistor structure 207. As with n-type transistor structure 206, integrated circuit structure 1000 may further include a frontside gate contact (not shown) in contact with gate structure 1011. Frontside source contact 1012, frontside drain contact 1013, and the frontside gate contact may be formed using any techniques and such components may include any materials and characteristics as discussed with respect to FIG. 10, and frontside source contact 1012, frontside drain contact 1013, and the frontside gate contact may be embedded in dielectric material 1004, which may be silicon oxide, silicon nitride, silicon oxynitride, or the like. For example, frontside source contact 1012, frontside drain contact 1013, and the frontside gate contact may include a liner material such as titanium nitride and a fill metal such as tungsten. As discussed, frontside metallization layers may be formed over integrated circuit structure 1000 as illustrated herein below with respect to FIG. 12.

With reference to FIGS. 10 and 11, integrated circuit structure 1000 includes n-type transistor structure 206 integrated with p-type transistor structure 207, such that n-type transistor structure 206 includes semiconductor structures 202 extending between source structure 211 and drain structure 212, gate structure 1001 coupled to semiconductor structures 202, and dipole layers 401 on semiconductor structures 202. Furthermore, p-type transistor structure 207 includes semiconductor structures 202 extending between source structure 221 and drain structure 222, and gate structure 1011 coupled to semiconductor structures 202, such that gate dielectric layers 701 of gate structure 1011 are on semiconductor structures 202.

Returning to FIG. 1, processing continues at operation 109, where backside metallization is optionally fabricated opposite the frontside metallization with respect to a device layer including the discussed integrated structures, additional fabrication processes may be completed, and the resultant structure may be output. Such processing may include backend processing, dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

FIG. 12 is a cross-sectional side view of a multi-layer integrated circuit device structure 1200 incorporating n-type transistor structure 206 and p-type transistor structure 207, arranged in accordance with at least some embodiments of the present disclosure. Although illustrated and discussed with respect to n-type transistor structure 206 and p-type transistor structure 207 altered with use of backside source contacts, any integrated circuit structures discussed herein such n-type transistor structure 206 and p-type transistor structure 207 having frontside source contacts may be deployed in the context of multi-layer integrated circuit device structure 1200. As shown, multi-layer integrated circuit device structure 1200 is incorporated in integrated circuit (IC) die 1207 such that multi-layer integrated circuit device structure 1200 includes frontside metallization layers 1201 (or frontside interconnect layers) and backside metallization layers 1202 (or backside interconnect layers). Frontside metallization layers 1201 and backside metallization layers 1202 may be formed using any suitable technique or techniques such as dual damascene techniques, single damascene techniques, subtractive metallization patterning techniques, or the like. In some embodiments, backside metallization layers 1202 are not deployed.

In some embodiments, interconnectivity, signal routing, power-delivery, and the like may be provided by frontside metallization layers 1201. Adjacent metallization layers, such as metallization interconnects 1210, are interconnected by vias, such as vias 1203, that may be characterized as part of the metallization layers or between the metallization layers. As shown, in some embodiments, frontside metallization layers 1201 are formed over and immediately adjacent n-type transistor structure 1000 and p-type transistor structure 1100. In the illustrated example, frontside metallization layers 1201 include M0, V0, M1, M2/V1, M3/V2, and M4/V3. However, frontside metallization layers 1201 may include any number of metallization layers such as six, eight, or more metallization layers.

Similarly, backside metallization layers 1202, may be used for interconnectivity, signal routing, power-delivery, and any other suitable electrical connectivity. In some embodiments, frontside metallization layers 1201 are used exclusively for signal routing and backside metallization layers 1202 are used exclusively for power delivery. However, any interconnection architecture may be used. In the illustrated example, package level interconnects 1211 are provided on or over a device backside as bumps over a passivation layer 1205. However, package level interconnects 1211 may be provided using any suitable interconnect structures such as bond pads, solder bumps, etc. As shown, in some embodiments, backside metallization layers 1202 are formed over and immediately adjacent n-type transistor structure 1000 and p-type transistor structure 1100 such that a device layer 1204 including n-type transistor structure 1000 and p-type transistor structure 1100 is between frontside metallization layers 1201 and backside metallization layers 1202. In the illustrated example, backside metallization layers 1202 include BM0, BM1, and BM2 with intervening via layers. However, backside metallization layers 1202 may include any number of metallization layers such as three, four, or more metallization layers.

In some embodiments, an integrated circuit structure including n-type transistor structure 1000 and p-type transistor structure 1100 is deployed in a monolithic integrated circuit (IC) die 1207 including gate-all-around field effect transistor structures (e.g., a GAA-FET) including any of the discussed components and characteristics. As shown, a power supply 1206 may be coupled to IC die 1207, such that power supply 1206 may include a battery, voltage converter, power supply circuitry, or the like.

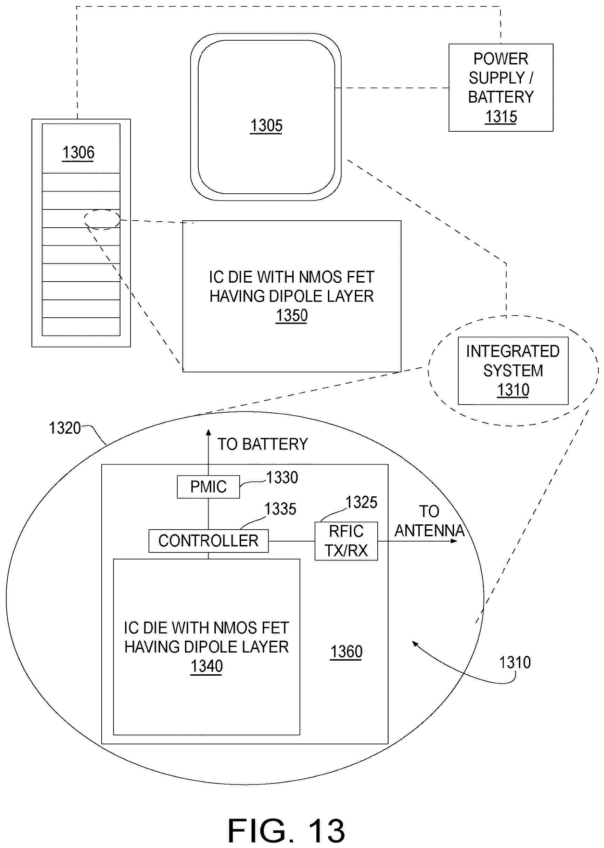

FIG. 13 illustrates exemplary systems employing integrated circuit structures with an n-type transistor integrated with a p-type transistor such that the n-type transistor has a layer including lanthanum on nanowires of the n-type transistor and the p-type transistor is absent the layer including lanthanum, in accordance with some embodiments. The system may be a mobile computing platform 1305 and/or a data server machine 1306, for example. Either may employ a component assembly including an IC die employing integrated circuit structures with an n-type transistor integrated with a p-type transistor such that the n-type transistor has a layer including lanthanum on nanowires of the n-type transistor and the p-type transistor is absent the layer including lanthanum as described elsewhere herein. Server machine 1306 may be any commercial server, for example including any number of high-performance computing platforms disposed within a rack and networked together for electronic data processing, which in the exemplary embodiment includes an IC die assembly 1350 with an IC die employing integrated circuit structures with an n-type transistor integrated with a p-type transistor such that the n-type transistor has a layer including lanthanum on nanowires of the n-type transistor and the p-type transistor is absent the layer including lanthanum as described elsewhere herein. Mobile computing platform 1305 may be any portable device configured for each of electronic data display, electronic data processing, wireless electronic data transmission, or the like. For example, mobile computing platform 1305 may be any of a tablet, a smart phone, a laptop computer, etc., and may include a display screen (e.g., a capacitive, inductive, resistive, or optical touchscreen), a chip-level or package-level integrated system 1310, and a battery 1315. Although illustrated with respect to mobile computing platform 1305, in other examples, chip-level or package-level integrated system 1310 and a battery 1315 may be implemented in a desktop computing platform, an automotive computing platform, an internet of things platform, or the like. As discussed below, in some examples, the disclosed systems may include a sub-system 1360 such as a system on a chip (SOC) or an integrated system of multiple ICs, which is illustrated with respect to mobile computing platform 1305.

Whether disposed within integrated system 1310 illustrated in expanded view 1320 or as a stand-alone packaged device within data server machine 1306, sub-system 1360 may include memory circuitry and/or processor circuitry 1340 (e.g., RAM, a microprocessor, a multi-core microprocessor, graphics processor, etc.), a power management integrated circuit (PMIC) 1330, a controller 1335, and a radio frequency integrated circuit (RFIC) 1325 (e.g., including a wideband RF transmitter and/or receiver (TX/RX)). As shown, one or more IC dies, such as memory circuitry and/or processor circuitry 1340 may be fabricated and implemented such that one or more have an IC die employing integrated circuit structures with an n-type transistor integrated with a p-type transistor such that the n-type transistor has a layer including lanthanum on nanowires of the n-type transistor and the p-type transistor is absent the layer including lanthanum as described herein. In some embodiments, RFIC 1325 includes a digital baseband and an analog front end module further comprising a power amplifier on a transmit path and a low noise amplifier on a receive path). Functionally, PMIC 1330 may perform battery power regulation, DC-to-DC conversion, etc., and so has an input coupled to battery 1315, and an output providing a current supply to other functional modules. As further illustrated in FIG. 13, in the exemplary embodiment, RFIC 1325 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1340 may provide memory functionality for sub-system 1360, high level control, data processing and the like for sub-system 1360. In alternative implementations, each of the SOC modules may be integrated onto separate ICs coupled to a package substrate, interposer, or board.

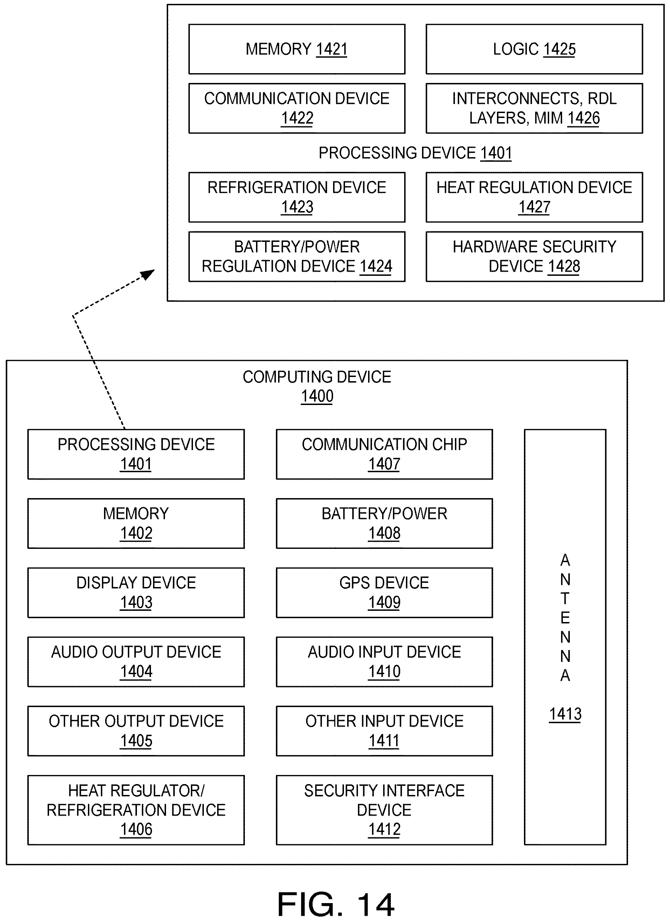

FIG. 14 is a block diagram of a computing device 1400, in accordance with some embodiments. For example, one or more components of computing device 1400 may include any of the integrated circuit structures with an n-type transistor integrated with a p-type transistor such that the n-type transistor has a layer including lanthanum on nanowires of the n-type transistor and the p-type transistor is absent the layer including lanthanum as discussed elsewhere herein. A number of components are illustrated in FIG. 14, but any one or more of these components may be omitted or duplicated, as suitable for the application. In some embodiments, some of the components included in computing device 1400 may be attached to one or more printed circuit boards (e.g., a motherboard). In some embodiments, various ones of these components may be fabricated onto a single system-on-a-chip (SoC) die or implemented with a disintegrated plurality of chiplets or tiles packaged together. Any of such packaged components may include integrated circuit structures with an n-type transistor integrated with a p-type transistor such that the n-type transistor has a layer including lanthanum on nanowires of the n-type transistor and the p-type transistor is absent the layer including lanthanum, for example, as discussed herein. Additionally, in various embodiments, computing device 1400 may not include one or more of the components illustrated in FIG. 14, but computing device 1400 may include interface circuitry for coupling to the one or more components. For example, computing device 1400 may not include a display device 1403, but may include display device interface circuitry (e.g., a connector and driver circuitry) to which display device 1403 may be coupled.

Computing device 1400 may include a processing device 1401 (e.g., one or more processing devices). As used herein, the term processing device or processor indicates a device that processes electronic data from registers and/or memory to transform that electronic data into other electronic data that may be stored in registers and/or memory. Processing device 1401 may include a memory 1421, a communication device 1422, a refrigeration/active cooling device 1423, a battery/power regulation device 1424, logic 1425, interconnects 1426, a heat regulation device 1427, and a hardware security device 1428.

Processing device 1401 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable compute units.

Processing device 1401 may include a memory 1402, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing device 1401 shares a package with memory 1402. This memory may be used as cache memory and may include embedded dynamic random-access memory (eDRAM) or spin transfer torque magnetic random-access memory (STT-M RAM).

Computing device 1400 may include a heat regulation/refrigeration device 1406. Heat regulation/refrigeration device 1406 may maintain processing device 1401 (and/or other components of computing device 1400) at a predetermined low temperature during operation. This predetermined low temperature may be any temperature discussed elsewhere herein.

In some embodiments, computing device 1400 may include a communication chip 1407 (e.g., one or more communication chips). For example, the communication chip 1407 may be configured for managing wireless communications for the transfer of data to and from computing device 1400. The term "wireless" and its derivatives may be used to describe circuits, devices, systems, methods, techniques, communications channels, etc., that may communicate data through the use of modulated electromagnetic radiation through a nonsolid medium.

Computing device 1400 may include any photonics structure discussed herein that may facilitate communication between one or more instances of processing device 1401 and/or one or more instances of memory 1402, for example.

Computing device 1400 may include battery/power circuitry 1408. Battery/power circuitry 1408 may include one or more energy storage devices (e.g., batteries or capacitors) and/or circuitry for coupling components of computing device 1400 to an energy source separate from computing device 1400 (e.g., AC line power).

Computing device 1400 may include a display device 1403 (or corresponding interface circuitry, as discussed above). Display device 1403 may include any visual indicators, such as a heads-up display, a computer monitor, a projector, a touchscreen display, a liquid crystal display (LCD), a light-emitting diode display, or a flat panel display, for example.

Computing device 1400 may include an audio output device 1404 (or corresponding interface circuitry, as discussed above). Audio output device 1404 may include any device that generates an audible indicator, such as speakers, headsets, or earbuds, for example.

Computing device 1400 may include an audio input device 1410 (or corresponding interface circuitry, as discussed above). Audio input device 1410 may include any device that generates a signal representative of a sound, such as microphones, microphone arrays, or digital instruments (e.g., instruments having a musical instrument digital interface (MIDI) output).

Computing device 1400 may include a global positioning system (GPS) device 1409 (or corresponding interface circuitry, as discussed above). GPS device 1409 may be in communication with a satellite-based system and may receive a location of computing device 1400, as known in the art.

Computing device 1400 may include another output device 1405 (or corresponding interface circuitry, as discussed above). Examples include an audio codec, a video codec, a printer, a wired or wireless transmitter for providing information to other devices, or an additional storage device.

Computing device 1400 may include another input device 1411 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1400 may include a security interface device 1412. Security interface device 1412 may include any device that provides security measures for computing device 1400 such as intrusion detection, biometric validation, security encode or decode, managing access lists, malware detection, or spyware detection.

Computing device 1400 may include an antenna 1413. Antenna 1413 may include any device that translates electrical current to radio waves and/or translates radio waves to electrical current.

Computing device 1400, or a subset of its components, may have any appropriate form factor, such as a server or other networked computing component, a mobile device, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

The following pertain to exemplary embodiments.

In one or more first embodiments, an apparatus comprises an n-type transistor comprising a first semiconductor structure extending between a first source structure and a first drain structure, and a first gate structure coupled to the first semiconductor structure, a material layer on the first semiconductor structure, the material layer comprising lanthanum, and a p-type transistor comprising a second semiconductor structure extending between a second source structure and a second drain structure, and a second gate structure coupled to the second semiconductor structure, such that the first gate structure comprises a gate dielectric material on the material layer, a first metal on the gate dielectric material, and a second metal on the first metal, and the second gate structure comprises the gate dielectric material on the second semiconductor structure, the first metal on the gate dielectric material, and the second metal on the first metal.

In one or more second embodiments, further to the first embodiments, the material layer has a thickness of not less than 5 angstroms.

In one or more third embodiments, further to the first or second embodiments, the first semiconductor structure comprises silicon and has a thickness of not less than 2 nm.

In one or more fourth embodiments, further to the first through third embodiments, wherein the first metal comprises titanium and nitrogen.

In one or more fifth embodiments, further to the first through fourth embodiments, the second metal comprises tungsten.

In one or more sixth embodiments, further to the first through fifth embodiments, the material layer comprises lanthanum and oxygen.

In one or more seventh embodiments, further to the first through sixth embodiments, the gate dielectric material comprises hafnium and oxygen.

In one or more eighth embodiments, further to the first through seventh embodiments, the apparatus further comprises an integrated circuit (IC) die comprising the n-type transistor, the material layer, and the p-type transistor, and a power supply coupled to the IC die.

In one or more ninth embodiments, an apparatus comprises an n-type transistor comprising a first nanowire extending between a first source and a first drain, and a first gate coupled to the first nanowire, a lanthanum layer on the first nanowire, and a p-type transistor comprising a second nanowire extending between a second source and a second drain, and a second gate coupled to the second nanowire, wherein such that the first gate comprises a gate dielectric material on the lanthanum layer, a work function metal on the gate dielectric material, and a bulk metal on the work function metal, and the second gate comprises the gate dielectric material on the second nanowire, the work function metal on the gate dielectric material, and the bulk metal on the work function metal.

In one or more tenth embodiments, further to the ninth embodiments, the first nanowire comprises silicon and has a thickness of not less than 2 nm and not more than 8 nm.

In one or more eleventh embodiments, further to the ninth or tenth embodiments, the lanthanum layer has a thickness of not less than 5 angstroms and not more than 20 angstroms.

In one or more twelfth embodiments, further to the ninth through eleventh embodiments, the work function metal comprises titanium and nitrogen.

In one or more thirteenth embodiments, further to the ninth through twelfth embodiments, the bulk metal comprises tungsten.

In one or more fourteenth embodiments, further to the ninth through thirteenth embodiments, the lanthanum layer further comprises oxygen.

In one or more fifteenth embodiments, further to the ninth through fourteenth embodiments, the gate dielectric material comprises hafnium and oxygen.

In one or more sixteenth embodiments, further to the ninth through fifteenth embodiments, the apparatus further comprises an integrated circuit (IC) die comprising the n-type transistor, the material layer, and the p-type transistor, and a power supply coupled to the IC die.

In one or more seventeenth embodiments, a method comprises forming a lanthanum layer on a first semiconductor structure of an n-type transistor structure and on a second semiconductor structure of a p-type transistor structure, removing the lanthanum layer from the second semiconductor structure to expose the second semiconductor structure, simultaneously forming a gate dielectric material on the lanthanum layer on the first semiconductor structure and on the exposed second semiconductor structure, and coupling a first gate electrode to the first semiconductor structure and a second gate electrode to the second semiconductor structure.

In one or more eighteenth embodiments, further to the seventeenth embodiments, coupling the first gate electrode to the first semiconductor structure and the second gate electrode to the second semiconductor structure comprises simultaneously forming a metal layer on the gate dielectric material.

In one or more nineteenth embodiments, further to the seventeenth or eighteenth embodiments, the gate dielectric material comprises hafnium and oxygen, and the metal layer comprises titanium and nitrogen.

In one or more twentieth embodiments, further to the seventeenth through nineteenth embodiments, coupling the first gate electrode to the first semiconductor structure and the second gate electrode to the second semiconductor structure comprises simultaneously forming a second metal layer on the metal layer.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
an n-type transistor comprising a first semiconductor structure extending between a first source structure and a first drain structure, and a first gate structure coupled to the first semiconductor structure;
a material layer on the first semiconductor structure, the material layer comprising lanthanum; and
a p-type transistor comprising a second semiconductor structure extending between a second source structure and a second drain structure, and a second gate structure coupled to the second semiconductor structure, wherein:
the first gate structure comprises a gate dielectric material on the material layer, a first metal on the gate dielectric material, and a second metal on the first metal, and
the second gate structure comprises the gate dielectric material on the second semiconductor structure, the first metal on the gate dielectric material, and the second metal on the first metal.

2. The apparatus of claim 1, wherein the material layer has a thickness of not less than 5 angstroms.

3. The apparatus of claim 1 or 2, wherein the first semiconductor structure comprises silicon and has a thickness of not less than 2 nm.

4. The apparatus of any of claims 1 to 3, wherein the first metal comprises titanium and nitrogen.

5. The apparatus of claim 4, wherein the second metal comprises tungsten.

6. The apparatus of any of claims 1 to 5, wherein the material layer comprises lanthanum and oxygen.

7. The apparatus of any of claims 1 to 6, wherein the gate dielectric material comprises hafnium and oxygen.

8. The apparatus of any of claims 1 to 7, further comprising:
an integrated circuit (IC) die comprising the n-type transistor, the material layer, and the p-type transistor; and
a power supply coupled to the IC die.

9. A method, comprising:
forming a lanthanum layer on a first semiconductor structure of an n-type transistor structure and on a second semiconductor structure of a p-type transistor structure;
removing the lanthanum layer from the second semiconductor structure to expose the second semiconductor structure;
simultaneously forming a gate dielectric material on the lanthanum layer on the first semiconductor structure and on the exposed second semiconductor structure; and
coupling a first gate electrode to the first semiconductor structure and a second gate electrode to the second semiconductor structure.

10. The method of claim 9, wherein coupling the first gate electrode to the first semiconductor structure and the second gate electrode to the second semiconductor structure comprises simultaneously forming a metal layer on the gate dielectric material.

11. The method of claim 10, wherein the metal layer comprises titanium and nitrogen.

12. The method of claim 10, wherein coupling the first gate electrode to the first semiconductor structure and the second gate electrode to the second semiconductor structure comprises simultaneously forming a second metal layer on the metal layer.

13. The method of any of claims 9 to 12, wherein the gate dielectric material comprises hafnium and oxygen.

14. The method of any of claims 9 to 13, wherein the lanthanum layer has a thickness of not less than 5 angstroms and not more than 20 angstroms.

15. The method of any of claims 9 to 14, wherein the first semiconductor structure comprises silicon and has a thickness of not less than 2 nm and not more than 8 nm.
